# EUROPEAN PATENT APPLICATION

(11) **EP 4 207 200 A1**
(43) Date of publication of application: **05.07.2023**
(21) Application number: 20950947.0
(22) Date of filing: 31.08.2020
(51) Int. Cl.: G11C 11/16

(54) **MEMORY**

(71) Applicant: Huawei Technologies Co., Ltd., Shenzhen, Guangdong 518129 (CN)
(72) Inventor: ZHOU, Xue, Shenzhen, Guangdong 518129 (CN); QIN, Qing, Shenzhen, Guangdong 518129 (CN); LU, Peng, Shenzhen, Guangdong 518129 (CN); ZHU, Jinghua, Shenzhen, Guangdong 518129 (CN)
(74) Representative: Huawei European IPR
(86) International application number: PCT/CN2020/112729
(87) International publication number: WO 2022/041278

(57) **Abstract**

Embodiments of this application provide a memory, and relate to a storage field, to reduce an area and power consumption of the memory when write flexibility is ensured. The memory includes a plurality of storage units distributed in an array. The storage unit includes an orbit torque providing line. A free layer of a first MTJ is connected to the orbit torque providing line. A free layer of a second MTJ is connected to the orbit torque providing line. The orbit torque providing line is further connected to a first bit line, a second bit line, and a third bit line. Connection ends of the first bit line and the second bit line on the orbit torque providing line are respectively located on two sides of the first MTJ and the second MTJ. A connection end of the third bit line on the orbit torque providing line is located between the first MTJ and the second MTJ.

## Description

### TECHNICAL FIELD

This application relates to the storage field, and in particular, to a memory.

### BACKGROUND

A magnetic random access memory (magnetic random access memory, MRAM) has advantages such as non-volatility, high density, high read/write speed, and radiation resistance. A core storage unit of the magnetic random memory is a sandwich film layer structure formed through successively stacking a reference layer, a tunneling layer, and a free layer. The reference layer and the free layer generally use a magnetic material, for example, cobalt iron boron CoFeB. The tunneling layer uses a non-magnetic insulating material, for example, magnesium oxide MgO. Generally, when magnetization states of magnetic materials on an upper interface and a lower interface of the tunneling layer are a parallel (parallel) state, resistance of a storage unit is in a low resistance state, which is denoted as "0". In an anti-parallel (anti-parallel) state, the resistance of the storage unit is in a high resistance state, which is denoted as "1". A memory reading circuit determines a magnitude of an output current through adding a read voltage with a small amplitude to the storage unit, to determine that information of the memory is "0" or "1".

Currently, a basic write principle used by a large-capacity magnetic random access memory product in the market is: Based on a current-induced magnetization reversal effect, also referred to as a spin transfer torque (spin transfer torque, STT for short), a drive current generated by a transistor flows through a storage unit in a forward direction or a reverse direction to change a magnetization state of the free layer, thereby implementing different magnetization states (parallel or anti-parallel) of magnetic materials on the upper interface and the lower interface of the tunneling layer and implementing writing of data "0" and "1". Because a write current of the current spin transfer torque STT-MRAM is excessively large, a size of the transistor configured to generate a drive current cannot continuously decrease with the core storage unit, thereby limiting further miniaturization of a storage area of the STT-MRAM.

An MRAM written based on the spin orbit torque (spin orbit torque, SOT for short) is excellent in terms of write power consumption, a write speed, and endurance. A basic structure of a storage unit of the SOT-MRAM is a reference layer, a tunneling layer, a free layer, and a spin orbit torque providing line (a thickness is generally several nanometers). A forward or reverse drive current is introduced into the spin orbit torque providing line, to implement reversal of a magnetization direction of the free layer, thereby recording the data "0" and " 1". A biggest bottleneck of the SOT-MRAM is that one storage unit needs to be connected to two drive transistors. As a result, the storage unit has an excessive large area of the storage unit. A single storage unit generally records one bit, that is, two states "0" and "1". Therefore, how to reduce power consumption and a storage area when write flexibility is ensured is an important target of performance optimization.

### SUMMARY

This application provides a memory, to reduce an area and power consumption of the memory when write flexibility is ensured.

According to a first aspect, a memory is provided. The memory includes a plurality of storage units distributed in an array. The storage unit includes an orbit torque providing line, a first magnetic tunnel junction MTJ (magnetic tunnel junction), and a second magnetic tunnel junction MTJ. A free layer of the first MTJ is connected to the orbit torque providing line. A free layer of the second MTJ is connected to the orbit torque providing line. The orbit torque providing line is further connected to a first bit line, a second bit line, and a third bit line. Connection ends of the first bit line and the second bit line on the orbit torque providing line are respectively located on two sides of the first MTJ and the second MTJ. A connection end of the third bit line on the orbit torque providing line is located between the first MTJ and the second MTJ. For example, the orbit torque providing line is also referred to as a spin orbit torque providing line, and is a heavy metal or metal alloy thin film with a nanoscale thickness, for example, platinum, tantalum, tungsten, and a tantalum tungsten alloy. The first MTJ includes a sandwich film layer structure formed by a reference layer, a tunneling layer, and the free layer that are stacked on the orbit torque providing line. The second MTJ includes a sandwich film layer structure formed by a reference layer, a tunneling layer, and the free layer that are stacked on the orbit torque providing line. The reference layer and the free layer are generally magnetic layers formed by using a magnetic material, for example, cobalt iron boron CoFeB. The tunneling layer includes a non-magnetic insulating material, for example, magnesium oxide MgO. The memory provided in the foregoing solution includes the storage units distributed in the array. The storage unit includes the orbit torque providing line, the first magnetic tunnel junction MTJ, and the second MTJ. The free layer of the first MTJ is connected to the orbit torque providing line. The free layer of the second MTJ is connected to the orbit torque providing line. The connection ends of the first bit line and the second bit line on the orbit torque providing line are respectively located on two sides of the first MTJ and the second MTJ. The connection end of the third bit line on the orbit torque providing line is located between the first MTJ and the second MTJ. In this way, in a write state, signals provided by the first bit line, the second bit line, and the third bit line are used to change a resistance value of the first MTJ and/or the second MTJ; and in a read state, a total resistance value that is of the first MTJ and the second MTJ and that is read from the reference layer of the first MTJ and the reference layer of the second MTJ is used to indicate data stored in the storage unit. Under control of the first bit line, the second bit line, and the third bit line, total resistance of two MTJs in one storage unit has three or four different resistance value states. In this way, three or four data write states may be indicated. Therefore, storage and reading in the three or four data states can be implemented. In the conventional technologies, one storage unit can store only one bit for indicating two states. In comparison, in this way, an area and power consumption of the memory can be reduced when write flexibility is ensured.

In a possible implementation, a first electrode is disposed on the reference layer of the first MTJ, a second electrode is disposed on the reference layer of the second MTJ, the second electrode is configured to receive a read voltage, and the first electrode is configured to output a read current.

In a possible implementation, the second electrode and the first electrode are connected to a current detection circuit, the detection circuit is configured to: input the read voltage to the second electrode, and detect the read current of the first electrode, and the total resistance value that is of the first MTJ and the second MTJ and that corresponds to the read current indicates the data stored in the storage unit. In this case, the total resistance value of the first MTJ and the second MTJ of the storage unit may be calculated based on the read voltage applied by the current detection circuit to the second electrode and the read current detected at the first electrode.

In a possible implementation, the first MTJ and the second MTJ have the same size or different sizes. If the first MTJ and the second MTJ have the same size, when the free layer and the reference layer of the first MTJ are in a parallel state and the free layer and the reference layer of the second MTJ are in the parallel state, the resistance value of the first MTJ is the same as the resistance value of the second MTJ, or when the free layer and the reference layer of the first MTJ are in an anti-parallel state and the free layer and the reference layer of the second MTJ are in the anti-parallel state, the resistance value of the first MTJ is the same as the resistance value of the second MTJ. Alternatively, if the first MTJ and the second MTJ have different sizes, when the free layer and the reference layer of the first MTJ are in a parallel state and the free layer and the reference layer of the second MTJ are in the parallel state, the resistance value of the first MTJ is different from the resistance value of the second MTJ, or when the free layer and the reference layer of the first MTJ are in an anti-parallel state and the free layer and the reference layer of the second MTJ are in the anti-parallel state, the resistance value of the first MTJ is different from the resistance value of the second MTJ.

In a possible implementation, the reference layer of the first MTJ is connected to a source line, and the reference layer of the second MTJ is connected to a read word line by using a gating switch. After the read word line gates the gating switch, the total resistance value of the first MTJ and the second MTJ is read from the source line and the read word line.

In a possible implementation, the orbit torque providing line is connected to a first bit line by using a first switch, and a control end of the first switch is connected to a write word line. The orbit torque providing line is connected to a second bit line by using a second switch, and a control end of the second switch is connected to the write word line. In a write state, the write word line controls the first switch and the second switch to be on.

According to a second aspect, a memory is provided, including storage units distributed in an array. The storage unit includes n serially connected tunnel junctions, where n is an integer greater than or equal to 2. A first end of an i^{th} tunnel junction is connected to an i^{th} bit line. A second end of the i^{th} tunnel junction is connected to an (i+1)^{th} bit line. For example, the tunnel junction includes an MTJ or a ferroelectric tunnel junction FTJ (ferroelectric tunnel junction, FTJ). The memory provided in the foregoing solution includes the storage units distributed in the array, and includes the storage units distributed in the array. The storage unit includes the n serially connected tunnel junctions, where n is an integer greater than or equal to 2. The first end of the i^{th} tunnel junction is connected to the i^{th} bit line. The second end of the i^{th} tunnel junction is connected to the (i+1)^{th} bit line. In this way, in a write state, the bit line is configured to change resistance of a tunnel junction. In a read state, the total resistance value that is of the n serially connected tunnel junctions and that is read at the first bit line and the (n+1)^{th} bit line is used to indicate data stored in the storage unit. Under control of the bit lines, total resistance of the n serially connected magnetic tunnel junctions in the storage unit has a plurality of different resistance value states. In this way, a plurality of data write states may be indicated. Therefore, storage and reading in the plurality of data states can be implemented. In the conventional technologies, one storage unit can store only one bit for indicating two states. In comparison, in this way, an area and power consumption of the memory can be reduced when write flexibility is ensured.

In a possible implementation, a first end of a first tunnel junction is connected to a current detection circuit by using a first bit line, a second end of the i^{th} tunnel junction is connected to the current detection circuit by using the (i+1)^{th} bit line, the current detection circuit is configured to: input a read voltage on the first bit line, and detect a read current on the (i+1)^{th} bit line, and the total resistance value that is of the n serially connected tunnel junctions and that corresponds to the read current indicates data stored in the storage unit. In this case, the total resistance value of the n tunnel junctions of the storage unit may be calculated based on the read voltage applied by the current detection circuit to the first end of the first tunnel junction and the read current detected at the second end of the i^{th} tunnel junction.

In a possible implementation, the tunnel junctions have the same size or different sizes.

In a possible implementation, the MTJ includes a reference layer, a tunneling layer, and a free layer, and when magnetization directions of the reference layer and the free layer are the same, the MTJ is a first resistor; or when magnetization directions of the reference layer and the free layer are different, the MTJ is a second resistor.

In a possible implementation, the FTJ includes a first electrode, a ferroelectric layer, and a second electrode, and when the ferroelectric layer is in a first polarization direction, the FTJ is a first resistor; or when the ferroelectric layer is in a second polarization direction, the FTJ is a second resistor.

In a possible implementation, the first end of the first tunnel junction is connected to the first bit line by using a first switch, and a second end of an n^{th} tunnel junction is connected to an (n+1)^{th} bit line by using a second switch; and a control end of the first switch and a control end of the second switch are connected to a word line. In the write state or the read state, the word line controls the first switch and the second switch to be on.

According to a third aspect, an electronic device is provided, including a circuit board and a memory connected to the circuit board. The memory is the memory according to the foregoing description.

### BRIEF DESCRIPTION OF DRAWINGS

FIG. 1 is a schematic diagram of a structure of a storage system according to an embodiment of this application;
FIG. 2 is a schematic diagram of a structure of a storage system according to another embodiment of this application;
FIG. 3 is a schematic diagram of a structure of a storage system according to still another embodiment of this application;
FIG. 4 is a schematic diagram of a structure of a memory according to an embodiment of this application;
FIG. 5 is a schematic diagram of a structure of a memory according to another embodiment of this application;
FIG. 6 is a schematic diagram of a structure of a memory according to still another embodiment of this application;
FIG. 7 is a schematic diagram of a structure of a memory according to yet another embodiment of this application;
FIG. 8 is a schematic diagram of a structure of a memory according to still yet another embodiment of this application;
FIG. 9 is a schematic diagram of a structure of a memory according to a further embodiment of this application;
FIG. 10 is a schematic diagram of a structure of an MTJ according to an embodiment of this application;
FIG. 11 is a schematic diagram of a structure of an FTJ according to an embodiment of this application;
FIG. 12 is a schematic diagram of a structure of an energy band of an FTJ according to an embodiment of this application;
FIG. 13 is a schematic diagram of a structure of a memory according to another embodiment of this application;
FIG. 14 is a schematic diagram of a structure of a memory according to still another embodiment of this application;
FIG. 15 is a schematic diagram of a structure of a memory according to yet another embodiment of this application; and
FIG. 16 is a schematic diagram of a structure of a memory according to still yet another embodiment of this application.

### DESCRIPTION OF EMBODIMENTS

The making and using of embodiments are discussed in detail below. It should be appreciated, however, that this application provides many applicable inventive concepts that can be embodied in a wide variety of specific contexts. Specific embodiments discussed herein are merely illustrative of specific manners to use and practice the specification and technology herein, and do not limit the scope of this application.

Unless defined otherwise, all technical and scientific terms used herein have the same meaning as commonly understood by those of ordinary skill in the art to which this specification pertains.

Circuits or other components may be described as or referred to as "used" to perform one or more tasks. In this case, "configured to" is used to connote a structure through indicating that the circuits/components include a structure (for example, a circuit system) that performs the task or tasks during operation. Therefore, the circuits/components can be configured to perform the task even when the specified circuits/components are not currently operational (for example, not on). The circuits/components used in conjunction with the "configured to" phrase include hardware, for example, a circuit configured to perform operations.

The following describes technical solutions in embodiments of this application with reference to the accompanying drawings in embodiments of this application. In this application, "at least one" means one or more, and "a plurality of" means two or more. "And/or" describes an association relationship between associated objects, and represents that three relationships may exist. For example, A and/or B may represent the following cases: Only A exists, both A and B exist, and only B exists, where A and B may be singular or plural. The character "/" usually indicates an "or" relationship between associated objects. "At least one of the following items (pieces)" or a similar expression thereof refers to any combination of these items, including any combination of singular items (pieces) or plural items (pieces). For example, at least one of a, b, or c may indicate that a, b, c, a and b, a and c, b and c, or a, b, and c, where a, b, and c may be singular or plural. In addition, in this embodiment of this application, words such as "first" and "second" do not limit a quantity and a sequence.

It should be noted that, in this application, the term such as "example" or "for example" is used to represent giving an example, an illustration, or descriptions. Any embodiment or design scheme described as an "example" or "for example" in embodiments of this application should not be explained as being more preferred or having more advantages than another embodiment or design scheme. Exactly, use of the word "example", "for example", or the like is intended to present a related concept in a specific manner.

The technical solutions of this application may be applied to various storage systems using random memories. For example, the technical solutions of this application may be applied to a computer, or may be applied to a storage system that includes a memory or includes a processor and a memory. The processor may be a central processing unit (central processing unit, CPU), an artificial intelligence (artificial intelligence, AI) processor, a digital signal processor (digital signal processor), a neural network processor, or the like.

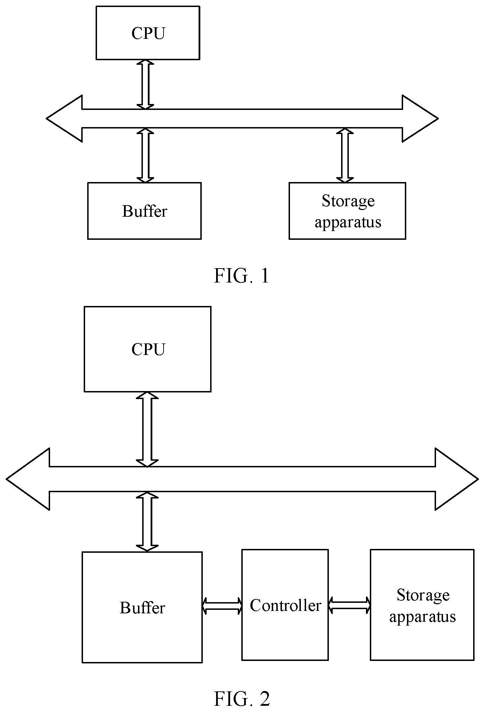

FIG. 1 is a schematic diagram of a structure of a storage system according to an embodiment of this application. The storage system may include a storage apparatus. The storage apparatus may be a random access memory. Optionally, the storage system may further include a CPU, a cache (cache), a controller, and the like.

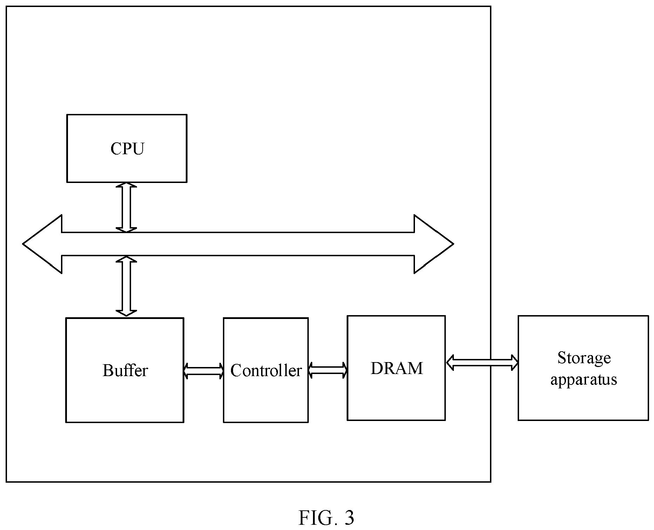

In an embodiment, as shown in FIG. 1, the storage system may be an embedded memory, and the storage system includes a CPU, a cache, and a storage apparatus that are integrated with each other. In another embodiment, as shown in FIG. 2, the storage system may be an independent memory, and the storage system includes a CPU, a cache, a controller, and a storage apparatus that are integrated with each other. The storage apparatus is coupled to the CPU by using the controller and the cache. In still another embodiment, as shown in FIG. 3, the storage system includes a storage apparatus, and a CPU, a cache, a controller, and a dynamic random access memory (dynamic random access memory, DRAM) that are integrated with each other. The storage apparatus may be coupled to the DRAM as an external storage apparatus. The DRAM is coupled to the CPU by using the controller and the cache. The CPU in each memory shown in FIG. 1, FIG. 2, and FIG. 3 may also be replaced with a CPU core (core).

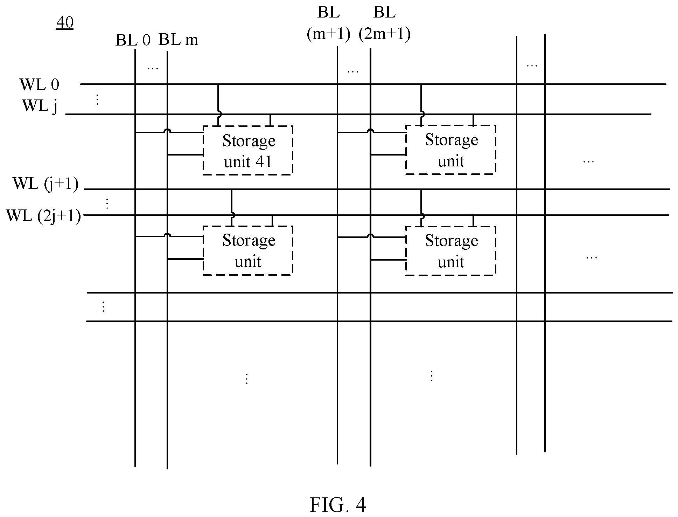

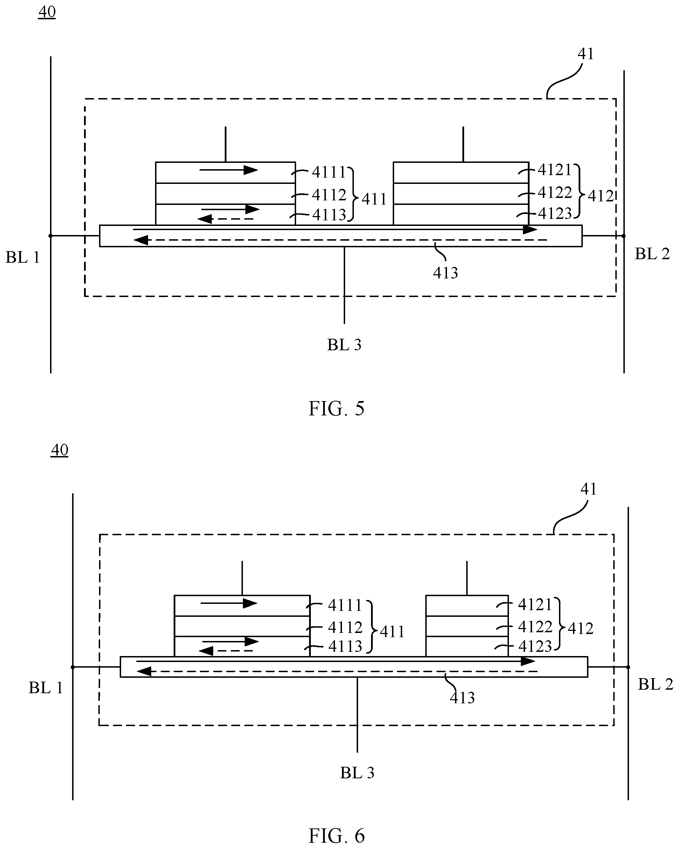

An embodiment of this application provides a structure of a memory 40. As shown in FIG. 4 and FIG. 5, the memory 40 includes storage units 41 distributed in an array. As shown in FIG. 4, the memory 40 includes the storage units arranged in a form of an x*y array. Herein, a plurality of BLs (BL 0-BL (2m+1)) and a plurality of WLs (WL 0-WL (2j+1)) are included. Each storage unit is separately connected to one or more bit lines (bit line, BL) and one or more word lines (word line, WL). For example, the storage units 41 are connected to bit lines BL 0-BL m and word lines WL 0-WL j. A read/write operation of a storage unit can be controlled through controlling the BL and the WL.

Specifically, as shown in FIG. 5, the storage unit 41 includes an orbit torque providing line 413, a first magnetic tunnel junction (magnetic tunnel junction, MTJ) 411, and a second MTJ 412. The first MTJ 411 and the second MTJ 412 may be located on the same side of the orbit torque providing line 413, or are respectively located on two sides of the orbit torque providing line 413. The orbit torque providing line 413 is further connected to a first bit line BL 1, a second bit line BL 2, and a third bit line BL 3. Connection ends of the first bit line BL 1 and the second bit line BL 2 on the orbit torque providing line 413 are respectively located on two sides of the first MTJ 411 and the second MTJ 412. A connection end of the third bit line BL 3 on the orbit torque providing line 413 is located between the first MTJ 411 and the second MTJ 412.

For example, the orbit torque providing line 413 is also referred to as a spin orbit torque providing line (the following solution is described by using the spin orbit torque providing line as an example). The spin orbit torque providing line is a heavy metal or metal alloy thin film with a nanoscale thickness, for example, platinum, tantalum, tungsten, and a tantalum tungsten alloy. In addition, as shown in FIG. 5, the first MTJ 411 includes a sandwich film layer structure formed by a reference layer 4111, a tunneling layer 4112, and the free layer 4113 that are stacked on the orbit torque providing line 413. The second MTJ 412 includes a sandwich film layer structure formed by a reference layer 4121, a tunneling layer 4122, and the free layer 4123 that are stacked on the orbit torque providing line 413. The reference layer and the free layer are generally magnetic layers formed by using a magnetic material, for example, cobalt iron boron CoFeB. The tunneling layer includes a non-magnetic insulating material, for example, magnesium oxide MgO. A current flowing through the orbit torque providing line 413 can generate a spin current that acts on a magnetic layer. A generated spin orbit torque causes magnification reversal of the free layer 4113/4123. A forward or reverse current is introduced into the orbit torque providing line 413. Electrons with different spin directions act on the magnetic layer, thereby implementing writing in a high resistance state and a low resistance state. When magnetization directions of the reference layer and the free layer are the same (that is, the reference layer and the free layer are in the parallel state in the following solutions), the MTJ is in a low resistance state, and the MTJ is a first resistor Rp. When magnetization directions of the reference layer and the free layer are different (that is, the reference layer and the free layer are in an anti-parallel state in the following solutions), the MTJ is in a high resistance state, and the MTJ is a second resistor Rap.

Based on the foregoing principle, in a write state, signals provided by the first bit line BL 1, the second bit line BL 2, and the third bit line BL 3 are used to change a resistance value of the first MTJ 411 and/or the second MTJ 412. In a read state, a total resistance value that is of the first MTJ and the second MTJ and that is read from the reference layer 4111 of the first MTJ 411 and the reference layer 4121 of the second MTJ 412 are used to indicate data stored in the storage unit.

In this embodiment of this application, sizes of the first MTJ 411 and the second MTJ 412 are not limited. In other words, the sizes of the first MTJ 411 and the second MTJ 412 are the same or different.

When the free layer 4113 and the reference layer 4111 of the first MTJ 411 are in the parallel state and the free layer 4123 and the reference layer 4121 of the second MTJ 412 are in the parallel state, the resistance value of the first MTJ 411 and the resistance value of the second MTJ 412 are both in a low resistance state. When the sizes of the first MTJ 411 and the second MTJ 412 are the same, the resistance values of the first MTJ 411 and the second MTJ 412 are the same. When the free layer 4113 and the reference layer 4111 of the first MTJ 411 are in the anti-parallel state and the free layer 4123 and the reference layer 4121 of the second MTJ 412 are in the anti-parallel state, the resistance value of the first MTJ 411 and the resistance value of the second MTJ 412 are both in a high resistance state. When the sizes of the first MTJ 411 and the second MTJ 412 are the same, the resistance values of the first MTJ 411 and the second MTJ 412 are the same.

As shown in FIG. 5, description is provided by using an example in which the sizes of the first MTJ 411 and the second MTJ 412 are the same. With reference to Table 1, voltages of the signals provided by the first bit line BL 1, the second bit line BL 2, and the third bit line BL 3, and a correspondence between the write state of the storage unit and a resistance value of an MTJ at a corresponding voltage are provided.

**Table 1**

| Write state | Voltage of the BL 1 | Voltage of the BL 2 | Voltage of the BL 3 | Resistance value of the first MTJ | Resistance value of the second MTJ | Total resistance value |
|---|---|---|---|---|---|---|
| State 1 | Vw1 | 0 | Suspended | Rp1 | Rp2 | Rp1+Rp2 |
| State 2 | 0 | Vw2 | Suspended | Rap 1 | Rap2 | Rap1+Rap2 |
| State 3 | Vw1' | Vw2' | 0 | Rp1 | Rap2 | Rp1+Rap2 |

In the write state, magnitudes of voltages: Vw1, Vw2, Vw1', and Vw2' need to be capable of changing a magnetization state of a free layer of an MTJ. Herein, "suspended" indicates that the BL 3 is null connected, that is, the BL 3 does not access any signal. Specifically, for example, in the state 1, the voltage of the BL 1 is Vw1, the voltage of the BL 2 is 0, and the BL 3 is suspended. In this case, there is one current direction in the spin orbit torque providing line. The current direction is a direction of a solid line arrow in FIG. 5 (from the BL 1 to the BL 2). In this case, magnetization states of a free layer and a reference layer of each of two MTJs are in the parallel state (with reference to FIG. 5, a magnetization direction of the reference layer 4111 (a direction of a solid line arrow in the reference layer 4111) and a magnetization direction of the free layer 4113 (a direction of a solid line arrow in the free layer 4113)). The resistance value of the first MTJ is Rp1. The resistance value of the second MTJ is Rp2. The total resistance value of the first MTJ and the second MTJ is Rp1+Rp2. This is equivalent to writing and recording first data in the storage unit. For example, "00" is recorded in a binary system. In the state 2, the voltage of the BL 1 is 0, the voltage of the BL 2 is Vw2, and the BL 3 is suspended. In this case, a current direction in the spin orbit torque providing line is reversed to a direction of a dashed line arrow (from the BL 2 to the BL 1) in FIG. 5. Magnetization reversal occurs in the free layer 4113/4123 (with reference to FIG. 5, a direction of a dashed line arrow in the free layer 4113). In this case, magnetization states of a free layer and a reference layer of each of two MTJs are in the anti-parallel state. The resistance value of the first MTJ is Rap1. The resistance value of the second MTJ is Rap2. The total resistance value of the first MTJ and the second MTJ is Rap 1+Rap2. This is equivalent to writing and recording second data in the storage unit. For example, "11" is recorded in a binary system. In the state 3, the voltage of the BL 1 is Vw1', the voltage of the BL 2 is Vw2', and the voltage of the BL 3 is 0. In this case, there are two current directions in the spin orbit torque providing line. A current direction 1 is from the BL 1 to the BL 3. A current direction 2 is from the BL 2 to the BL 3. In this case, magnetization states of the free layer and the reference layer of the first MTJ are in the parallel state, and magnetization states of the free layer and the reference layer of the second MTJ are in the anti-parallel state. The resistance value of the first MTJ is Rp1. The resistance value of the second MTJ is Rap2. The total resistance value of the first MTJ and the second MTJ is Rp1+Rap2. This is equivalent to writing and recording third data in the storage unit. For example, "01" is recorded in a binary system. During reading, the total resistance values corresponding to the foregoing three write states are different. Therefore, when a specific voltage value is input between the reference layers of the two MTJs, the total resistance value of the two MTJs may be determined based on a current between the reference layers of the two MTJs, so that the total resistance value is mapped to corresponding data in each state. Certainly, in the state 3, alternatively, the voltage of the BL 1 is 0, the voltage of the BL 2 is 0, and the voltage of the BL 3 is Vw'. Herein, Vw'>0. In this case, there are two current directions in the spin orbit torque providing line. A current direction 1 is from the BL 3 to the BL 1. A current direction 2 is from the BL 3 to the BL 2. In this case, magnetization states of the free layer and the reference layer of the first MTJ are in the anti-parallel state, and magnetization states of the free layer and the reference layer of the second MTJ are in the parallel state. The resistance value of the first MTJ is Rap1. The resistance value of the second MTJ is Rp2. The total resistance value of the first MTJ and the second MTJ is Rap1+Rp2. This is equivalent to writing and recording third data in the storage unit. For example, "10" is recorded in a binary system. Because the sizes of the first MTJ 411 and the second MTJ 412 are the same, Rap1+Rp2=Rp1+Rap2. Therefore, in the state 3, only one piece of data can be used for mapping. In other words, the total resistance value in the state 3 can only be mapped to either one of "10" or "01". Certainly, in some examples, specific values of Vw1, Vw2, Vw1', Vw2', and Vw' are not limited. Because a current direction in a spin orbit torque providing line determines the magnetization direction of the free layer, in the state 1, the current direction is from the BL 1 to the BL 2 when the voltage Vw1>0; in the state 2, the current direction is from the BL 2 to the BL 1 when the voltage Vw2>0; and in the state 3, the current direction is from the BL 1 to the BL 3 and from the BL 2 to the BL 3 when Vw1'>0 and Vw2'>0; or in the state 3, the current direction is from the BL 2 to the BL 1 and from the BL 3 to the BL 2 when Vw'>0. Magnitudes of the values of Vw1, Vw2, Vw1', Vw2', and Vw' can ensure that the magnitude of the current is enabled to change the magnetization direction of the free layer.

When the free layer 4113 and the reference layer 4111 of the first MTJ 411 are in the parallel state and the free layer 4123 and the reference layer 4121 of the second MTJ 412 are in the parallel state, the resistance value of the first MTJ 411 and the resistance value of the second MTJ 412 are both in the low resistance state. When the sizes of the first MTJ 411 and the second MTJ 412 are different, the resistance values of the first MTJ 411 and the second MTJ 412 are different. When the free layer 4113 and the reference layer 4111 of the first MTJ 411 are in the anti-parallel state and the free layer 4123 and the reference layer 4121 of the second MTJ 412 are in the anti-parallel state, the resistance value of the first MTJ 411 and the resistance value of the second MTJ 412 are both in the high resistance state. When the sizes of the first MTJ 411 and the second MTJ 412 are different, the resistance values of the first MTJ 411 and the second MTJ 412 are different.

As shown in FIG. 6, description is provided by using an example in which the sizes of the first MTJ 411 and the second MTJ 412 are different. With reference to Table 2, the voltages of the signals provided by the first bit line BL 1, the second bit line BL 2, and the third bit line BL 3, and a correspondence between the write state of the storage unit and a resistance value of an MTJ at a corresponding voltage are provided.

**Table 2**

| Write state | Voltage of the BL 1 | Voltage of the BL 2 | Voltage of the BL 3 | Resistance value of the first MTJ | Resistance value of the second MTJ | Total resistance value |
|---|---|---|---|---|---|---|
| State 1 | Vw1 | 0 | Suspended | Rp1 | Rp2 | Rp1+Rp2 |
| State 2 | 0 | Vw2 | Suspended | Rap1 | Rap2 | Rap1+Rap2 |
| State 3 | Vw1' | Vw2' | 0 | Rp1 | Rap2 | Rp1+Rap2 |
| State 4 | 0 | 0 | Vw | Rap1 | Rp1 | Rap1+Rp2 |

In the write state, magnitudes of voltages: Vw1 and Vw2 need to be capable of changing a magnetization state of a free layer of an MTJ. Herein, "suspended" indicates that the BL 3 is null connected, that is, the BL 3 does not access any signal. The solution shown in FIG. 6 is used as an example. It is assumed that the resistance value of the first MTJ in the high resistance state is greater than the resistance value of the second MTJ in the high resistance state, and the resistance value of the first MTJ in the low resistance state is greater than the resistance value of the second MTJ in the low resistance state. Specifically, for example, in the state 1, the voltage of the BL 1 is Vw1, the voltage of the BL 2 is 0, and the BL 3 is suspended. In this case, there is one current direction in the spin orbit torque providing line. The current direction is a direction of a solid line arrow in FIG. 6 (from the BL 1 to the BL 2). In this case, magnetization states of a free layer and a reference layer of each of two MTJs are in the parallel state. The resistance value of the first MTJ is Rp1. The resistance value of the second MTJ is Rp2. The total resistance value of the first MTJ and the second MTJ is Rp1+Rp2. This is equivalent to writing and recording first data in the storage unit. For example, "00" is recorded in a binary system. In the state 2, the voltage of the BL 1 is 0, the voltage of the BL 2 is Vw2, and the BL 3 is suspended. In this case, a current direction in the spin orbit torque providing line is reversed to a direction of a dashed line arrow (from the BL 2 to the BL 1) in FIG. 6. Magnetization reversal occurs on the free layer 4113/4123. In this case, magnetization states of a free layer and a reference layer of each of two MTJs are in the anti-parallel state. The resistance value of the first MTJ is Rap1. The resistance value of the second MTJ is Rap2. The total resistance value of the first MTJ and the second MTJ is Rap1+Rap2. This is equivalent to writing and recording second data in the storage unit. For example, "11" is recorded in a binary system. Because the sizes of the first MTJ and the second MTJ are different, Rp1≠Rp2, and Rap1≠Rap2. Therefore, total resistance of the two MTJs when the first MTJ is in the parallel state and the second MTJ is in the anti-parallel state is different from total resistance of the two MTJs when the first MTJ is in the anti-parallel state and the second MTJ is in the parallel state. Therefore, the two write states may be recorded. In the state 3, the voltage of the BL 1 is Vw1', the voltage of the BL 2 is Vw2', and the voltage of the BL 3 is 0. In this case, there are two current directions in the spin orbit torque providing line. A current direction 1 is from the BL 1 to the BL 3. A current direction 2 is from the BL 2 to the BL 3. In this case, the magnetization states of the free layer and the reference layer of the first MTJ are in the parallel state, and the magnetization states of the free layer and the reference layer of the second MTJ are in the anti-parallel state. The resistance value of the first MTJ is Rp1. The resistance value of the second MTJ is Rap2. The total resistance value of the first MTJ and the second MTJ is Rp1+Rap2. This is equivalent to writing and recording third data in the storage unit. For example, "01" is recorded in a binary system. In the state 4, the voltage of the BL 1 is 0, the voltage of the BL 2 is 0, and the voltage of the BL 3 is Vw. In this case, there are two current directions in the spin orbit torque providing line. A current direction 1 is from the BL 3 to the BL 1. A current direction 2 is from the BL 3 to the BL 2. In this case, the magnetization states of the free layer and the reference layer of the first MTJ are in the parallel state, and the magnetization states of the free layer and the reference layer of the second MTJ are in the parallel state. The resistance value of the first MTJ is Rap1. The resistance value of the second MTJ is Rp2. The total resistance value of the first MTJ and the second MTJ is Rap1+Rp2. This is equivalent to writing and recording fourth data in the storage unit. For example, "10" is recorded in a binary system. During reading, because the total resistance values corresponding to the foregoing four write states are different, when a specific voltage value is input between the reference layers of the two MTJs, the total resistance value of the two MTJs may be determined based on a current between the reference layers of the two MTJs, so that the total resistance value is mapped to corresponding data in each state. Certainly, in some examples, specific values of Vw1, Vw2, Vw1', Vw2', and Vw are not limited. Because the current direction in the spin orbit torque providing line determines the magnetization direction of the free layer, in the state 1, the current direction is from the BL 1 to the BL 2 when the voltage Vw1>0; in the state 2, the current direction is from the BL 2 to the BL 1 when the voltage Vw2>0; in the state 3, the current direction is from the BL 1 to the BL 3 and from the BL 2 to the BL 3 when Vw1'>0 and Vw2'>0; and in the state 4, the current direction is from the BL 3 to the BL 1 and from the BL 3 to the BL 2 when Vw>0. Magnitudes of the values of Vw1, Vw2, Vw1', Vw2', and Vw can ensure that the magnitude of the current is enabled to change the magnetization direction of the free layer.

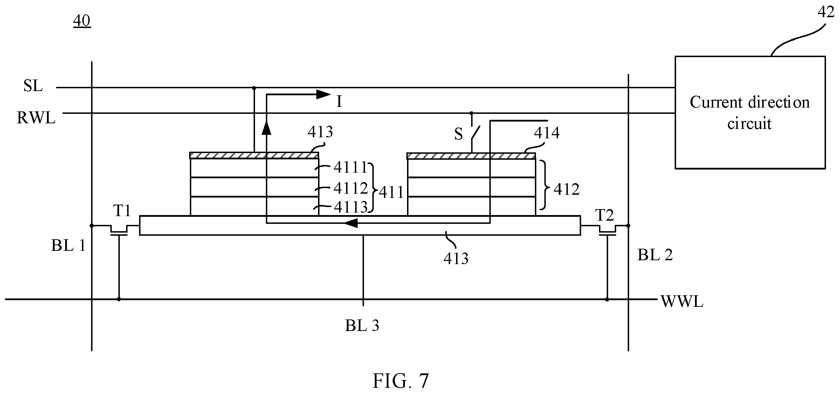

As shown in FIG. 7, the reference layer 4111 of the first MTJ 411 is connected to a source line SL, and the reference layer 4121 of the second MTJ 412 is connected to a read word line RWL (read WL, where the RWL may be one WL in FIG. 7) by using a gating switch S. After the read word line RWL gates the gating switch S, the total resistance value of the first MTJ 411 and the second MTJ 412 is read from the source line SL and the read word line RWL. The gating switch SL may be a Schottky barrier diode. For example, the RWL is connected to a negative electrode of the Schottky barrier diode, and a positive electrode of the Schottky barrier diode is connected to the reference layer 4121 of the second MTJ 412. In this way, after the Schottky barrier diode is gated by using a signal input by the RWL, a signal input by the SL may enter the RWL by using the first MTJ and the second MTJ. In this way, the total resistance value of the two MTJs is determined through detecting the signal passing through the first MTJ and the second MTJ. FIG. 7 shows a current direction I of the signal passing through the first MTJ and the second MTJ.

As shown in FIG. 7, the orbit torque providing line 413 is connected to a first bit line BL 1 by using a first switch T1, and a control end of the first switch T1 is connected to a write word line WWL (write WL, where the WWL may be one WL in FIG. 7). The orbit torque providing line 413 is connected to a second bit line BL 2 by using a second switch T2, and a control end of the second switch T2 is connected to the write word line WWL. In the write state, the write word line WWL controls the first switch T1 and the second switch T2 to be on.

As shown in FIG. 7, a first electrode 413 is disposed on the reference layer of the first MTJ 411, a second electrode 414 is disposed on the reference layer of the second MTJ 412, the second electrode 414 is configured to receive a read voltage, and the first electrode 413 is configured to output a read current. Specifically, as shown in FIG. 7, the second electrode 414 and the first electrode 413 are connected to a current detection circuit 42, the detection circuit 42 is configured to: input the read voltage to the second electrode 414, and detect the read current of the first electrode 413, and the total resistance value that is of the first MTJ and the second MTJ and that corresponds to the read current indicates the data stored in the storage unit. As shown in FIG. 7, the first electrode 413 is connected to the current detection circuit 42 by using the source line SL, and the second electrode 414 is connected to the current detection circuit 42 by using the RWL. In this case, the total resistance value of the first MTJ and the second MTJ of the storage unit may be calculated based on the read voltage applied by the current detection circuit 42 to the second electrode and the read current detected at the first electrode.

The memory provided in the foregoing solution includes the storage units distributed in the array. The storage unit includes the orbit torque providing line, the first magnetic tunnel junction MTJ, and the second MTJ. The free layer of the first MTJ is connected to the orbit torque providing line. The free layer of the second MTJ is connected to the orbit torque providing line. Connection ends of the first bit line and the second bit line on the orbit torque providing line are respectively located on two sides of the first MTJ and the second MTJ. A connection end of a third bit line on the orbit torque providing line is located between the first MTJ and the second MTJ. In this way, in a write state, signals provided by the first bit line, the second bit line, and the third bit line are used to change a resistance value of the first MTJ and/or the second MTJ; and in a read state, the total resistance value that is of the first MTJ and the second MTJ and that is read from the reference layer of the first MTJ and the reference layer of the second MTJ is used to indicate data stored in the storage unit. Under control of the first bit line, the second bit line, and the third bit line, total resistance of two MTJs in one storage unit has three or four different resistance value states. In this way, three or four data write states may be indicated. Therefore, storage and reading in the three or four data states can be implemented. In the conventional technologies, one storage unit can store only one bit for indicating two states. In comparison, in this way, an area and power consumption of the memory are reduced in the present invention when write flexibility is ensured.

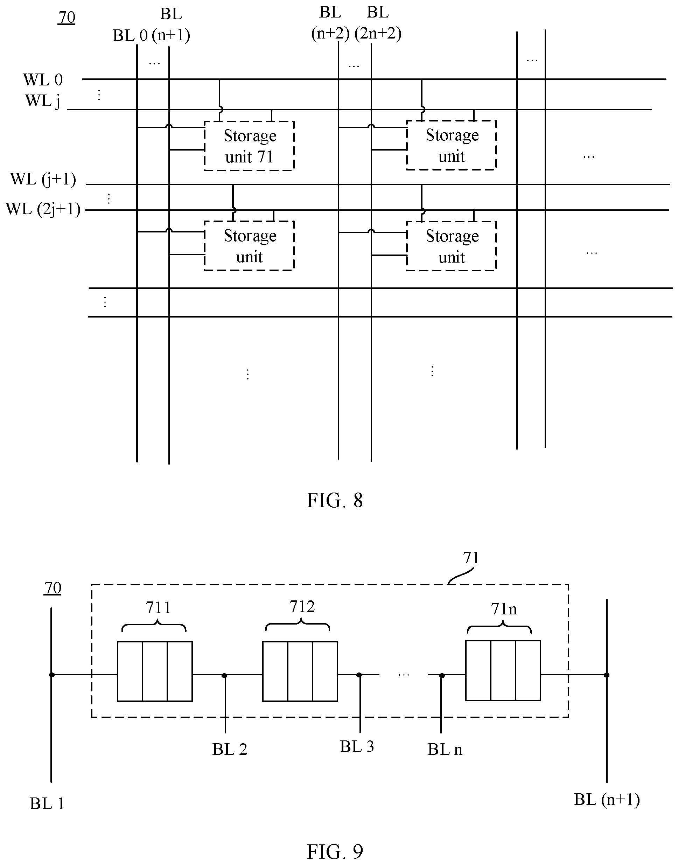

An embodiment of this application provides a structure of a memory 70. With reference to FIG. 8 and FIG. 9, the memory 70 includes storage units 71 distributed in an array. As shown in FIG. 8, the memory 70 includes the storage units arranged in a form of an x*y array. Herein, a plurality of BLs (BL 0-BL (2n+2)) and a plurality of WLs (WL 0-WL (2j+1)) are included. Each storage unit is separately connected to one or more bit lines (bit line, BL) and one or more word lines (word line, WL). For example, the storage units 71 are connected to BL 0-BL (n+1) and WL 0-WL j. A read/write operation of a storage unit can be controlled through controlling the BL and the WL.

Specifically, as shown in FIG. 9, the storage unit 71 includes n serially connected tunnel junctions (711-71n), where n is an integer greater than or equal to 2. A first end of an i^{th} tunnel junction is connected to an i^{th} bit line. A second end of the i^{th} tunnel junction is connected to an (i+1)^{th} bit line. For example, as shown in FIG. 9, a first end of the first tunnel junction 711 is connected to the first bit line BL 1, and a second end is connected to the second bit line BL 2; a first end of a second tunnel junction 712 is connected to the second bit line BL 2, and a second end is connected to the third bit line BL 3; and a first end of an n^{th} tunnel junction 71n is connected to an n^{th} bit line BL n, and a second end is connected to an (n+1)^{th} bit line BL (n+1). For example, the tunnel junction includes an MTJ or a ferroelectric tunnel junction (ferroelectric tunnel junction, FTJ) described above.

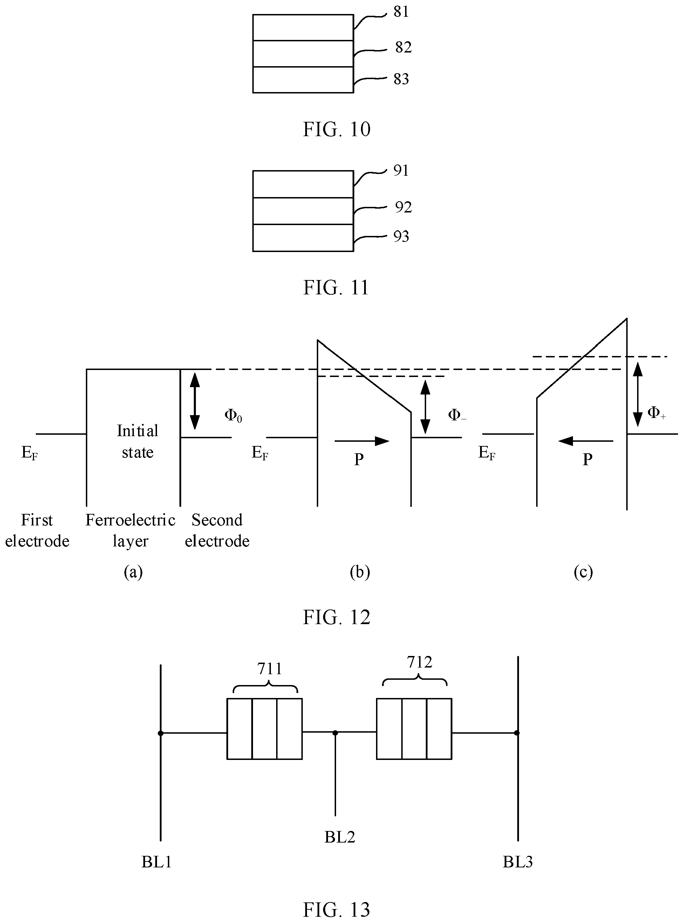

As shown in FIG. 10, the MTJ includes a sandwich film layer structure formed through successively stacking a reference layer 81, a tunneling layer 82, and a free layer 83. The reference layer and the free layer are generally magnetic layers formed by using a magnetic material, for example, cobalt iron boron CoFeB. The tunneling layer includes a non-magnetic insulating material, for example, magnesium oxide MgO. The reference layer 81 is a first end of the tunnel junction, and the free layer 83 is a second end of the tunnel junction. Alternatively, the reference layer 81 is a second end of the tunnel junction, and the free layer 83 is a first end of the tunnel junction. When magnetization directions of the reference layer 81 and the free layer 83 are the same, the reference layer 81 and the free layer 83 are in a parallel state, the MTJ is in a low resistance state, and the MTJ is a first resistor Rp. When magnetization directions of the reference layer 81 and the free layer 83 are different, the reference layer 81 and the free layer 83 are in an anti-parallel state, the MTJ is in a high resistance state, and the MTJ is a second resistor Rap. A working principle of the MTJ is as follows: A current flowing through the MTJ can cause reversal of a magnetization state of the free layer.

As shown in FIG. 11, the FTJ includes a first electrode 91, a ferroelectric layer 92, and a second electrode 93 that are stacked. The first electrode 91 and the second electrode 93 generally use a conductive material. For example, the conductive material includes a metal material, for example, tungsten (W), nickel (Ni), platinum (Pt), ruthenium (Ru), iridium (Ir), cobalt (Co), aluminum (Al), copper (Cu), titanium (Ti), or titanium nitride (TiN). The ferroelectric layer 92 may include at least one of the following materials: lead zirconate titanate (PbZrTiO₃), strontium bismuth tantalate (SrBi₂Ta₂O₉), hafnium dioxide (HfO₂) (note: zirconium (Zr), aluminum (Al), silicon (Si), lanthanum (La), and the like may be doped in HfO₂). The first electrode 91 is a first end of the tunnel junction, and the second electrode 93 is a second end of the tunnel junction. Alternatively, the first electrode 91 is a second end of the tunnel junction, and the second electrode 93 is a first end of the tunnel junction. Generally, the ferroelectric layer has only a thickness of several atomic layers. When the ferroelectric layer 92 is in a first polarization direction, the FTJ is a first resistor. When the ferroelectric layer 92 is in a second polarization direction, the FTJ is a second resistor. Specifically, as shown in FIG. 12, a resistance-changing mechanism of the FTJ is to adjust and control a polarization state of the ferroelectric layer through applying an electric field, change a height of a barrier, and cause a change of resistance in the tunnel junction and further adjust and control a magnitude of a tunneling current. In an initial state, a barrier of the ferroelectric layer shown in FIG. 12(a) is ϕ0. When the polarization direction of the ferroelectric layer is adjusted and controlled through applying an electric field to be from P to right (from left to right in FIG. 12(b)), the barrier of the ferroelectric layer is ϕ-, the FTJ is in a low resistance state, and the FTJ is a first resistor Rr. When the polarization direction of the ferroelectric layer is adjusted and controlled through applying an electric field to be from P to left (from right to left in FIG. 12(c)), the barrier of the ferroelectric layer is ϕ+, the FTJ is a high resistance state, and the FTJ is a second resistor Rl. Therefore, there are two resistance states: high and low in the ferroelectric tunnel junction, which may be used to indicate two logical states: "1" and "0", thereby implementing data storage.

Based on the foregoing principle, in a write state, a signal provided by the bit line (BL 1-BL (n+1)) is used to change resistance of the tunnel junction (711-71n); and in a read state, a total resistance value that is of the n serially connected tunnel junctions (711-71n) and that is read from the first bit line BL 1 and the (n+1)^{th} bit line BL (n+1) is used to indicate the data stored in the storage unit.

In this embodiment of this application, sizes of the tunnel junctions are not limited. In other words, the sizes of the tunnel junctions may be the same or different.

For example, as shown in FIG. 13, an example in which the storage unit includes two serially connected tunnel junctions (711 and 712) is used. If the tunnel junction uses an MTJ, when the tunnel junction 711 is in a parallel state and the tunnel junction 712 is in the parallel state, a resistance value of the tunnel junction 711 and a resistance value of the tunnel junction 712 are in a low resistance state. When sizes of the tunnel junction 711 and the tunnel junction 712 are the same, the resistance values of the tunnel junction 711 and the tunnel junction 712 are the same. When the tunnel junction 711 is in an anti-parallel state and the tunnel junction 712 is in the anti-parallel state, a resistance value of the tunnel junction 711 and a resistance value of the tunnel junction 712 are in a high resistance state. When sizes of the tunnel junction 711 and the tunnel junction 712 are the same, the resistance values of the tunnel junction 711 and the tunnel junction 712 are the same. If the tunnel junction uses the FTJ, when polarization directions of the tunnel junction 711 and the tunnel junction 712 are the same, the resistance value of the tunnel junction 711 and the resistance value of the tunnel junction 712 are the same.

As shown in FIG. 13, an example in which the tunnel junction 711 and the tunnel junction 712 are MTJs with the same size (the tunnel junction 711 is an MTJ 1, and the tunnel junction 712 is an MTJ 2) is used for description. With reference to Table 3, the voltages of the signals provided by the first bit line BL 1, the second bit line BL 2, and the third bit line BL 3, and a correspondence between the write state of the storage unit and a resistance value of an MTJ at a corresponding voltage are provided.

**Table 3**

| Write state | Voltage of the BL 1 | Voltage of the BL 2 | Voltage of the BL 3 | Resistance value of the MTJ 1 | Resistance value of the MTJ 2 | Total resistance value |
|---|---|---|---|---|---|---|
| State 1 | Vw1 | Suspended | 0 | Rp1 | Rp2 | Rp1+Rp2 |
| State 2 | 0 | Suspended | Vw2 | Rap1 | Rap2 | Rap1+Rap2 |
| State 3 | Vw1' | 0 | Vw2' | Rp1 | Rap2 | Rp1+Rap2 |

In the write state, magnitudes of voltages: Vw1, Vw2, Vw1', and Vw2' need to be capable of changing a magnetization state of a free layer of an MTJ. Herein, "suspended" indicates that the BL 2 is null connected, that is, the BL 2 does not access any signal. Specifically, for example, in the state 1, the voltage of the BL 1 is Vw1, the voltage of the BL 3 is 0, and the BL 2 is suspended. In this case, there is one current direction (the current direction is from the BL 1 to the BL 3) in the storage unit. In this case, magnetization states of the free layer and the reference layer of each of the two MTJs are in the parallel state. The resistance value of the MTJ 1 is Rp1. The resistance value of the MTJ 2 is Rp2. The total resistance value of the MTJ 1 and the MTJ 2 is Rp1+Rp2. This is equivalent to writing and recording first data in the storage unit. For example, "00" is recorded in a binary system. In the state 2, the voltage of the BL 1 is 0, the voltage of the BL 3 is Vw2, and the BL 2 is suspended. In this case, a current direction in the storage unit is reversed (the current direction is from the BL 3 to the BL 1). In this case, magnetization states of the free layer and the reference layer of each of the two MTJs are in an anti-parallel state. The resistance value of the MTJ 1 is Rap1. The resistance value of the MTJ 2 is Rap2. The total resistance value of the MTJ 1 and the MTJ 2 is Rap1+Rap2. This is equivalent to writing and recording second data in the storage unit. For example, "11" is recorded in a binary system. In the state 3, the voltage of the BL 1 is Vw1', the voltage of the BL 2 is 0, and the voltage of the BL 3 is Vw2'. In this case, there are two current directions in the storage unit. A current direction 1 is from the BL 1 to the BL 2. A current direction 2 is from the BL 3 to the BL 2. In this case, magnetization states of the free layer and the reference layer of the MTJ 1 are in a parallel state, and magnetization states of the free layer and the reference layer of the MTJ 2 are in an anti-parallel state. The resistance value of the MTJ 1 is Rp1. The resistance value of the MTJ 2 is Rap2. The total resistance value of the MTJ 1 and the MTJ 2 is Rp1+Rap2. This is equivalent to writing and recording third data in the storage unit. For example, "01" is recorded in a binary system. During reading, because the total resistance values corresponding to the foregoing three write states are different, when a specific voltage value is input to the BL 1 and the BL 3, the total resistance value of the two MTJs may be determined based on a current flowing through the two MTJs, so that the total resistance value is mapped to corresponding data in each state. Certainly, in the state 3, alternatively, the voltage of the BL 1 is 0, the voltage of the BL 2 is Vw', and the voltage of the BL 3 is 0. Herein, Vw'>0. In this case, there are two current directions in the storage unit. A current direction 1 is from the BL 2 to the BL 1. A current direction 2 is from the BL 2 to the BL 3. In this case, magnetization states of the free layer and the reference layer of the MTJ 1 are in the anti-parallel state, and magnetization states of the free layer and the reference layer of the MTJ 2 are in the parallel state. The resistance value of the MTJ 1 is Rap1. The resistance value of the MTJ 2 is Rp2. The total resistance value of the MTJ 1 and the MTJ 2 is Rap1+Rp2. This is equivalent to writing and recording third data in the storage unit. For example, "10" is recorded in a binary system. Because the sizes of the MTJ 1 and the MTJ 2 are the same, Rap1+Rp2=Rp1+Rap2. Therefore, in the state 3, only one piece of data can be used for mapping. In other words, the total resistance value in the state 3 can only be mapped to either one of "10" or "01". Certainly, in some examples, specific values of Vw1, Vw2, Vw1', Vw2', and Vw' are not limited. Because a current direction in the storage unit determines a magnetization direction of the free layer, in the state 1, the current direction is from the BL 1 to the BL 3 when the voltage Vw1>0; in the state 2, the current direction is from the BL 3 to the BL 1 when the voltage Vw2>0; and in the state 3, the current direction is from the BL 1 to the BL 2 and from the BL 3 to the BL 2 when Vw1'>0 and Vw2'>0; or in the state 3, the current direction is from the BL 2 to the BL 1 and from the BL 2 to the BL 3 when Vw'>0. Magnitudes of the values of Vw1, Vw2, Vw1', Vw2', and Vw' can ensure that the magnitude of the current is enabled to change the magnetization direction of the free layer.

As shown in FIG. 13, an example in which the tunnel junction 711 and the tunnel junction 712 are FTJs with the same size (the tunnel junction 711 is an FTJ 1, and the tunnel junction 712 is an FTJ 2) is used for description. With reference to Table 4, the voltages of the signals provided by the first bit line BL 1, the second bit line BL 2, and the third bit line BL 3, and a correspondence between the write state of the storage unit and a resistance value of an FTJ at a corresponding voltage are provided.

**Table 4**

| Write state | Voltage of the BL 1 | Voltage of the BL 2 | Voltage of the BL 3 | Resistance value of the FTJ 1 | Resistance value of the FTJ 2 | Total resistance value |
|---|---|---|---|---|---|---|
| State 1 | Vw1 | Suspended | 0 | Rr1 | Rr2 | Rr1+Rr2 |
| State 2 | 0 | Suspended | Vw2 | Rl1 | Rl2 | Rl1+Rl2 |
| State 3 | Vw1' | 0 | Vw2' | Rr1 | Rl2 | Rr1+Rl2 |

In the write state, magnitudes of voltages: Vw1, Vw2, Vw1' (Vw1'<Vw1), and Vw2' (Vw2'<Vw2) need to be capable of changing a magnetization state of an FTJ. Herein, "suspended" indicates that the BL 2 is null connected, that is, the BL 2 does not access any signal. Specifically, for example, in the state 1, the voltage of the BL 1 is Vw1, the voltage of the BL 3 is 0, and the BL 2 is suspended. In this case, there is one current direction (the current direction is from the BL 1 to the BL 3) in the storage unit. Polarization directions of the two FTJs are the same and are both a first polarization direction, for example, rightward polarization. The resistance value of the FTJ 1 is Rr1. The resistance value of the FTJ 2 is Rr2. The total resistance value of the FTJ 1 and the FTJ 2 is Rr1+Rr2. This is equivalent to writing and recording first data in the storage unit. For example, "00" is recorded in a binary system. In the state 2, the voltage of the BL 1 is 0, the voltage of the BL 3 is Vw2, and the BL 2 is suspended. In this case, there is one current direction (the current direction is from the BL 3 to the BL 1) in the storage unit. Polarization directions of the two FTJs are the same and are both a second polarization direction, for example, leftward polarization. The resistance value of the FTJ 1 is Rl1. The resistance value of the FTJ 2 is Rl2. The total resistance value of the FTJ 1 and the FTJ 2 is Rl1+Rl2. This is equivalent to writing and recording second data in the storage unit. For example, "11" is recorded in a binary system. In the state 3, the voltage of the BL 1 is Vw1', the voltage of the BL 2 is 0, and the voltage of the BL 3 is Vw2'. In this case, there are two current directions in the storage unit. A current direction 1 is from the BL 1 to the BL 2. A current direction 2 is from the BL 3 to the BL 2. A polarization direction of the FTJ 1 is a first polarization direction, for example, rightward polarization. A polarization direction of the FTJ 2 is a second polarization direction, for example, leftward polarization. The resistance value of the FTJ 1 is Rr1. The resistance value of the FTJ 2 is Rl2. The total resistance value of the FTJ 1 and the FTJ 2 is Rr1+Rl2. This is equivalent to writing and recording third data in the storage unit. For example, "01" is recorded in a binary system. During reading, because the total resistance values corresponding to the foregoing three write states are different, when a specific voltage value is input to the BL 1 and the BL 3, the total resistance value of the two FTJs may be determined based on a current flowing through the two FTJs, so that the total resistance value is mapped to corresponding data in each state. Certainly, in the state 3, alternatively, the voltage of the BL 1 is 0, the voltage of the BL 2 is Vw', and the voltage of the BL 3 is 0. Herein, Vw'>0. In this case, there are two current directions in the storage unit. A current direction 1 is from the BL 2 to the BL 1. A current direction 2 is from the BL 2 to the BL 3. In this case, a polarization direction of the FTJ 1 is a second polarization direction, for example, leftward polarization; and a polarization direction of the FTJ 2 is a first polarization direction, for example, rightward polarization. The resistance value of the FTJ 1 is R11. The resistance value of the FTJ 2 is Rr2. The total resistance value of the FTJ 1 and the FTJ 2 is Rl1+Rr2. This is equivalent to writing and recording third data in the storage unit. For example, "10" is recorded in a binary system. Because the sizes of the FTJ 1 and the FTJ 2 are the same, Rl1+Rr2= Rr1+Rl2. Therefore, in the state 3, only one piece of data can be used for mapping. In other words, the total resistance value in the state 3 can only be mapped to either one of "10" or "01". Certainly, in some examples, specific values of Vw1, Vw2, Vw1', Vw2', and Vw' are not limited. Because a current direction in the storage unit determines a polarization direction of the FTJ, in the state 1, the current direction is from the BL 1 to the BL 3 when the voltage Vw1>0; in the state 2, the current direction is from the BL 3 to the BL 1 when the voltage Vw2>0; and in the state 3, the current direction is from the BL 1 to the BL 2 and from the BL 3 to the BL 2 when Vw1'>0 and Vw2'>0; or in the state 3, the current direction is from the BL 2 to the BL 1 and from the BL 2 to the BL 3 when Vw'>0. Magnitudes of the values of Vw1, Vw2, Vw1', Vw2', and Vw' can ensure that the magnitude of the current is enabled to change the polarization direction of the FTJ.

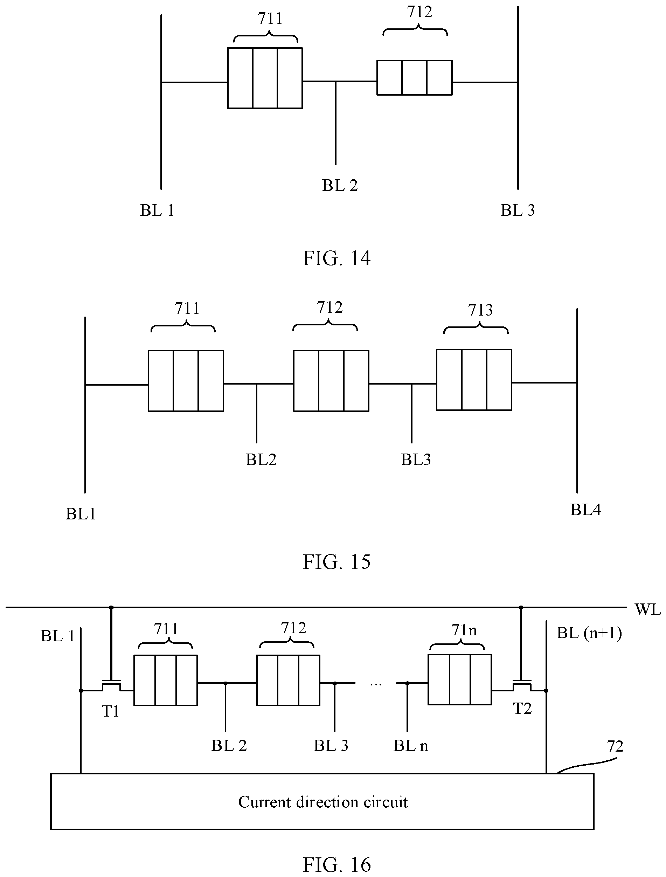

For example, as shown in FIG. 14, an example in which the storage unit includes two serially connected tunnel junctions (711 and 712) is used for description. If the tunnel junction uses an MTJ, when the tunnel junction 711 is in a parallel state and the tunnel junction 712 is in the parallel state, a resistance value of the tunnel junction 711 and a resistance value of the tunnel junction 712 are in a low resistance state. When sizes of the tunnel junction 711 and the tunnel junction 712 are different, the resistance values are different. When the tunnel junction 711 is in an anti-parallel state and the tunnel junction 712 is in the anti-parallel state, a resistance value of the tunnel junction 711 and a resistance value of the tunnel junction 712 are in a high resistance state. When sizes of the tunnel junction 711 and the tunnel junction 712 are different, the resistance values are different. If the tunnel junction uses the FTJ, when polarization directions of the tunnel junction 711 and the tunnel junction 712 are the same and sizes of the tunnel junction 711 and the tunnel junction 712 are different, the resistance value of the tunnel junction 711 and the resistance value of the tunnel junction 712 are different.

As shown in FIG. 14, an example in which the tunnel junction 711 and the tunnel junction 712 are MTJs with the same size (the tunnel junction 711 is an MTJ 1, and the tunnel junction 712 is an MTJ 2) is used for description. With reference to Table 5, the voltages of the signals provided by the first bit line BL 1, the second bit line BL 2, and the third bit line BL 3, and a correspondence between the write state of the storage unit and a resistance value of an MTJ at a corresponding voltage are provided.

**Table 5**

| Write state | Voltage of the BL 1 | Voltage of the BL 2 | Voltage of the BL 3 | Resistance value of the MTJ 1 | Resistance value of the MTJ 2 | Total resistance value |
|---|---|---|---|---|---|---|
| State 1 | Vw1 | Suspended | 0 | Rp1 | Rp2 | Rp1+Rp2 |
| State 2 | 0 | Suspended | Vw2 | Rap 1 | Rap2 | Rap1+Rap2 |
| State 3 | Vw1' | 0 | Vw2' | Rp1 | Rap2 | Rp1+Rap2 |
| State 4 | 0 | Vw | 0 | Rap1 | Rp1 | Rap1+Rp2 |

In the write state, magnitudes of voltages: Vw1, Vw2, Vw1', Vw2', and Vw need to be capable of changing a magnetization state of a free layer of an MTJ. Herein, "suspended" indicates that the BL 2 is null connected, that is, the BL 2 does not access any signal. Specifically, for example, in the state 1, the voltage of the BL 1 is Vw1, the voltage of the BL 3 is 0, and the BL 2 is suspended. In this case, there is one current direction in the storage unit. The current direction is from the BL 1 to the BL 3. Magnetization states of a free layer and a reference layer of each of two MTJs are in a parallel state. The resistance value of the MTJ 1 is Rp1. The resistance value of the MTJ 2 is Rp2. The total resistance value of the MTJ 1 and the MTJ 2 is Rp1+Rp2. This is equivalent to writing and recording first data in the storage unit. For example, "00" is recorded in a binary system. In the state 2, the voltage of the BL 1 is 0, the voltage of the BL 3 is Vw2, and the BL 2 is suspended. In this case, a current direction in the storage unit is reversed. The current direction is from the BL 3 to the BL 1. Magnetization reversal occurs on a free layer. Magnetization states of a free layer and a reference layer of each of two MTJs are in an anti-parallel state. The resistance value of the MTJ 1 is Rap1. The resistance value of the MTJ 2 is Rap2. The total resistance value of the MTJ 1 and the MTJ 2 is Rap1+Rap2. This is equivalent to writing and recording second data in the storage unit. For example, "11" is recorded in a binary system. Because the sizes of the MTJ 1 and the MTJ 2 are different, Rp1≠Rp2, and Rap1≠Rap2. Therefore, total resistance of the two MTJs when the MTJ 1 is in the parallel state and the MTJ 2 is in the anti-parallel state is different from total resistance of the two MTJs when the MTJ 1 is in the anti-parallel state and the MTJ 2 is in the parallel state. Therefore, the two write states may be recorded. In the state 3, the voltage of the BL 1 is Vw1', the voltage of the BL 3 is Vw2', and the voltage of the BL 2 is 0. In this case, there are two current directions in the storage unit. A current direction 1 is from the BL 1 to the BL 2. A current direction 2 is from the BL 3 to the BL 2. In this case, the magnetization states of the free layer and the reference layer of the MTJ 1 are in the parallel state, and the magnetization states of the free layer and the reference layer of the MTJ 2 are in the anti-parallel state. The resistance value of the MTJ 1 is Rp1. The resistance value of the MTJ 2 is Rap2. The total resistance value of the MTJ 1 and the MTJ 2 is Rp1+Rap2. This is equivalent to writing and recording third data in the storage unit. For example, "01" is recorded in a binary system. In the state 4, the voltage of the BL 1 is 0, the voltage of the BL 3 is 0, and the voltage of the BL 2 is Vw. In this case, there are two current directions in the storage unit. A current direction 1 is from the BL 2 to the BL 1. A current direction 2 is from the BL 2 to the BL 3. The magnetization states of the free layer and the reference layer of the MTJ 1 are in the anti-parallel state. The magnetization states of the free layer and the reference layer of the MTJ 2 are in the parallel state. The resistance value of the MTJ 1 is Rap1. The resistance value of the MTJ 2 is Rp2. The total resistance value of the MTJ 1 and the MTJ 2 is Rap1+Rp2. This is equivalent to writing and recording fourth data in the storage unit. For example, "10" is recorded in a binary system. During reading, because the total resistance values corresponding to the foregoing four write states are different, when a specific voltage value is input between the BL 1 and the BL 3, the total resistance value of the two MTJs may be determined based on a current flowing through the two MTJs, so that the total resistance value is mapped to corresponding data in each state. Certainly, in some examples, specific values of Vw1, Vw2, Vw1', Vw2', and Vw are not limited. Because a current direction in the storage unit determines a magnetization direction of the free layer, in the state 1, the current direction is from the BL 1 to the BL 3 when the voltage Vw1>0; in the state 2, the current direction is from the BL 3 to the BL 1 when the voltage Vw2>0; in the state 3, the current direction is from the BL 1 to the BL 2 and from the BL 3 to the BL 2 when Vw1'>0 and Vw2'>0; and in the state 4, the current direction is from the BL 2 to the BL 1 and from the BL 2 to the BL 3 when Vw>0. Magnitudes of the values of Vw1, Vw2, Vw1', Vw2', and Vw can ensure that the magnitude of the current is enabled to change the magnetization direction of the free layer.

As shown in FIG. 14, an example in which the tunnel junction 711 and the tunnel junction 712 are FTJs with different sizes (the tunnel junction 711 is an FTJ 1, and the tunnel junction 712 is an FTJ 2) is used for description. With reference to Table 4, the voltages of the signals provided by the first bit line BL 1, the second bit line BL 2, and the third bit line BL 3, and a correspondence between the write state of the storage unit and a resistance value of an FTJ at a corresponding voltage are provided.

**Table 6**

| Write state | Voltage of the BL 1 | Voltage of the BL 2 | Voltage of the BL 3 | Resistance value of the FTJ 1 | Resistance value of the FTJ 2 | Total resistance value |
|---|---|---|---|---|---|---|
| State 1 | Vw1 | Suspended | 0 | Rr1 | Rr2 | Rr1+Rr2 |
| State 2 | 0 | Suspended | Vw2 | Rl1 | Rl2 | Rl1+Rl2 |
| State 3 | Vw1' | 0 | Vw2' | Rr1 | Rl2 | Rr1+Rl2 |
| State 4 | 0 | Vw | 0 | Rl1 | Rr2 | Rl1+Rr2 |

In the write state, magnitudes of voltages: Vw1, Vw2, Vw1', Vw2', and Vw need to be capable of changing a polarization state of an FTJ. Herein, "suspended" indicates that the BL 2 is null connected, that is, the BL 2 does not access any signal. Specifically, for example, in the state 1, the voltage of the BL 1 is Vw1, the voltage of the BL 3 is 0, and the BL 2 is suspended. In this case, there is one current direction (the current direction is from the BL 1 to the BL 3) in the storage unit. Polarization directions of the two FTJs are the same and are both a first polarization direction, for example, rightward polarization. The resistance value of the FTJ 1 is Rr1. The resistance value of the FTJ 2 is Rr2. The total resistance value of the FTJ 1 and the FTJ 2 is Rr1+Rr2. This is equivalent to writing and recording first data in the storage unit. For example, "00" is recorded in a binary system. In the state 2, the voltage of the BL 1 is 0, the voltage of the BL 3 is Vw2, and the BL 2 is suspended. In this case, a current direction (the current direction is from the BL 3 to the BL 1) in the storage unit is reversed. Polarization directions of the two FTJs are the same and are both a second polarization direction, for example, leftward polarization. The resistance value of the FTJ 1 is R11. The resistance value of the FTJ 2 is R12. The total resistance value of the FTJ 1 and the FTJ 2 is Rl1+Rl2. This is equivalent to writing and recording second data in the storage unit. For example, "11" is recorded in a binary system. Because the sizes of the FTJ 1 and the FTJ 2 are different, Rr1≠Rr2, and Rl1≠Rl2. Therefore, total resistance of the two FTJs when the FTJ 1 is in the first polarization direction and the FTJ 2 is in the second polarization direction is different from total resistance of the two FTJs when the FTJ 1 is in the second polarization direction and the FTJ 2 is in the first polarization direction. Therefore, two write states may be recorded. In the state 3, the voltage of the BL 1 is Vw1', the voltage of the BL 3 is Vw2', and the voltage of the BL 2 is 0. In this case, there are two current directions in the storage unit. A current direction 1 is from the BL 1 to the BL 2. A current direction 2 is from the BL 3 to the BL 2. In this case, a polarization direction of the FTJ 1 is a first polarization direction, for example, rightward polarization; and a polarization direction of the FTJ 2 is a second polarization direction, for example, leftward polarization. The resistance value of the FTJ 1 is Rr1. The resistance value of the FTJ 2 is R12. The total resistance value of the FTJ 1 and the FTJ 2 is Rr1+Rl2. This is equivalent to writing and recording third data in the storage unit. For example, "01" is recorded in a binary system. In the state 4, the voltage of the BL 1 is 0, the voltage of the BL 3 is 0, and the voltage of the BL 2 is Vw. In this case, there are two current directions in the storage unit. A current direction 1 is from the BL 2 to the BL 1. A current direction 2 is from the BL 2 to the BL 3. In this case, a polarization direction of the FTJ 1 is a second polarization direction, for example, leftward polarization; and a polarization direction of the FTJ 2 is a first polarization direction, for example, rightward polarization. The resistance value of the FTJ 1 is Rl1. The resistance value of the FTJ 2 is Rr2. The total resistance value of the FTJ 1 and the FTJ 2 is Rl1+Rr2. This is equivalent to writing and recording fourth data in the storage unit. For example, "10" is recorded in a binary system. Because the total resistance values corresponding to the foregoing four write states are different, when a specific voltage value is input to the BL 1 and the BL 3, the total resistance value of the two FTJs may be determined based on a current flowing through the two FTJs, so that the total resistance value is mapped to corresponding data in each state. Certainly, in some examples, specific values of Vw1, Vw2, Vw1', Vw2', and Vw are not limited. Because a current direction in the storage unit determines a polarization direction of the FTJ, in the state 1, the current direction is from the BL 1 to the BL 3 when the voltage Vw1>0; in the state 2, the current direction is from the BL 3 to the BL 1 when the voltage Vw2>0; in the state 3, the current direction is from the BL 1 to the BL 2 and from the BL 3 to the BL 2 when Vw1'>0 and Vw2'>0; and in the state 4, the current direction is from the BL 2 to the BL 1 and from the BL 2 to the BL 3 when Vw>0. Magnitudes of the values of Vw1, Vw2, Vw1', Vw2', and Vw can ensure that the magnitude of the current is enabled to change the polarization direction of the FTJ.

As shown in FIG. 15, an example in which the storage unit includes three serially connected tunnel junctions (711, 712, and 713) is used. An example in which the tunnel junction 711, the tunnel junction 712, and the tunnel junction 713 are FTJs with the same size (the tunnel junction 711 is an FTJ 1, the tunnel junction 712 is an FTJ 2, and the tunnel junction 713 is an FTJ 3) is used for description. With reference to Table 7, voltages of signals provided by the first bit line BL 1, the second bit line BL 2, the third bit line BL 3, and a fourth bit line BL 4 and a correspondence between the write state of the storage unit and a resistance value of an FTJ at a corresponding voltage are provided.

**Table 7**

| Write state | Voltage of the BL 1 | Voltage of the BL 2 | Voltage of the BL 3 | Voltage of the BL 4 | Resistance value of the FTJ 1 | Resistance value of the FTJ 2 | Resistance value of the FTJ 3 | Total resistance value |
|---|---|---|---|---|---|---|---|---|
| State 1 | Vw1 | Suspended | Suspended | 0 | Rr | Rr | Rr | 3Rr |
| State 2 | 0 | Suspended | Suspended | Vw2 | Rl | Rl | Rl | 3R1 |
| State 3 | Vw1' | 0 | Suspended | Vw2' | Rr | Rl | Rl | Rr+2Rl |
| State 4 | Vw1" | Suspended | 0 | Vw2" | Rr | Rr | Rl | 2Rr+Rl |

In the write state, magnitudes of voltages: Vw1, Vw2, Vw1' (Vw1'<Vw1), Vw2' (Vw2'<Vw2), Vw1" (Vw1'<Vw1"<Vw1), and Vw2" (Vw2"<Vw2'<Vw2) need to be capable of changing a polarization state of an FTJ. Herein, "suspended" indicates that the BL 2/BL 3 is null connected, that is, the BL 2/BL 3 does not access any signal. Specifically, for example, in the state 1, the voltage of the BL 1 is Vw1, the BL 2 is suspended, the BL 3 is suspended, and the voltage of the BL 4 is 0. In this case, there is one current direction (the current direction is from the BL 1 to the BL 4) in the storage unit. Polarization directions of the three FTJs are the same and are all a first polarization direction, for example, rightward polarization r. The resistance values of the FTJ 1, the FTJ 2, and the FTJ 3 are Rr. The total resistance value of the FTJ 1, the FTJ 2, and the FTJ 3 is 3Rr. This is equivalent to writing and recording first data in the storage unit. For example, "00" is recorded in a binary system. In the state 2, the voltage of the BL 1 is 0, the BL 2 is suspended, the BL 3 is suspended, and the voltage of the BL 4 is Vw2. In this case, there is one current direction (the current direction is from the BL 4 to the BL 1) in the storage unit. Polarization directions of the three FTJs are the same and are all a second polarization direction, for example, leftward polarization. The resistance values of the FTJ 1, the FTJ 2, and the FTJ 3 are Rl. The total resistance value of the FTJ 1, the FTJ 2, and the FTJ 3 is 3Rl. This is equivalent to writing and recording second data in the storage unit. For example, "11" is recorded in a binary system. In the state 3, the voltage of the BL 1 is Vw1', the voltage of the BL 2 is 0, the BL 3 is suspended, and the voltage of the BL 4 is Vw2'. In this case, there are two current directions in the storage unit. A current direction 1 is from the BL 1 to the BL 2. A current direction 2 is from the BL 4 to the BL 2. In this case, a polarization direction of the FTJ 1 is a first polarization direction, for example, rightward polarization; and polarization directions of the FTJ 2 and the FTJ 3 are a second polarization direction, for example, leftward polarization. The resistance value of the FTJ 1 is Rr. The resistance values of the FTJ 2 and the FTJ 3 are Rl. The total resistance value of the FTJ 1, the FTJ 2, and the FTJ 3 is Rr+2Rl. This is equivalent to writing and recording third data in the storage unit. For example, "10" is recorded in a binary system. In the state 4, the voltage of the BL 1 is Vw1", the voltage of the BL 2 is suspended, the voltage of the BL 3 is 0', and the voltage of the BL 4 is Vw2". In this case, there are two current directions in the storage unit. A current direction 1 is from the BL 1 to the BL 3. A current direction 2 is from the BL 4 to the BL 3. In this case, polarization directions of the FTJ 1 and the FTJ 2 are a first polarization direction, for example, rightward polarization; and a polarization direction of the FTJ 3 is a second polarization direction, for example, leftward polarization. The resistance values of the FTJ 1 and the FTJ 2 are Rr. The resistance value of the FTJ 3 is Rl. The total resistance value of the FTJ 1, the FTJ 2, and the FTJ 3 is 2Rr+Rl. This is equivalent to writing and recording third data in the storage unit. For example, "01" is recorded in a binary system. During reading, because the total resistance values corresponding to the foregoing four write states are different, when a specific voltage value is input to the BL 1 and the BL 3, the total resistance value of the two FTJs may be determined based on a current flowing through the two FTJs, so that the total resistance value is mapped to corresponding data in each state. Certainly, in some examples, specific values of Vw1, Vw2, Vw1', Vw2', Vw 1", and Vw2" are not limited. Because a current direction in the storage unit determines a polarization direction of the FTJ, in the state 1, the current direction is from the BL 1 to the BL 4 when the voltage Vw1>0; in the state 2, the current direction is from the BL 4 to the BL 1 when the voltage Vw2>0; in the state 3, the current direction is from the BL 1 to the BL 2 and from the BL 4 to the BL 2 when Vw1'>0 and Vw2'>0; and in the state 4, the current direction is from the BL 1 to the BL 3 and from the BL 4 to the BL 3 when Vw1">0 and Vw2">0. Magnitudes of the values of Vw1, Vw2, Vw1', Vw2', Vw1", and Vw2" can ensure that the magnitude of the current is enabled to change the polarization direction of the FTJ.

As shown in FIG. 16, the first end of the first tunnel junction 711 is connected to the first bit line BL 1 by using a first switch T1, and a second end of the n^{th} tunnel junction 71n is connected to an (n+1)^{th} bit line BL (n+1) by using a second switch T2; and a control end of the first switch T1 and a control end of the second switch T2 are connected to a word line WL. In the write state or the read state, the word line WL controls the first switch T1 and the second switch T2 to be on.

As shown in FIG. 16, the first end of the first tunnel junction 711 is connected to a current detection circuit 72 by using the first bit line BL 1, a second end of an i^{th} tunnel junction 71n is connected to the current detection circuit 72 by using the (i+1)^{th} bit line BL (n+1), the current detection circuit 72 is configured to: input a read voltage on the first bit line, and detect a read current on the (i+1)^{th} bit line, and the total resistance value that is of the n serially connected tunnel junctions and that corresponds to the read current indicates data stored in the storage unit. In this case, the total resistance value of the n tunnel junctions of the storage unit may be calculated based on the read voltage applied by the current detection circuit 72 to the first end of the first tunnel junction 711 and the read current detected at the second end of the i^{th} tunnel junction 71n.

Certainly, the foregoing merely provides several examples. It may be understood that a person skilled in the art may further reasonably deduces, based on the foregoing solutions, a solution of implementing a plurality of write states when four or more tunnel junctions are connected in serials in one storage unit.

The memory provided in the foregoing solution includes the storage units distributed in the array, and includes the storage units distributed in the array. The storage unit includes the n serially connected tunnel junctions, where n is an integer greater than or equal to 2. The first end of the i^{th} tunnel junction is connected to the i^{th} bit line. The second end of the i^{th} tunnel junction is connected to the (i+1)^{th} bit line. In this way, in a write state, the bit line is configured to change resistance of a tunnel junction. In a read state, the total resistance value that is of the n serially connected tunnel junctions and that is read at the first bit line and the (n+1)^{th} bit line is used to indicate data stored in the storage unit. Under control of the bit lines, the total resistance of the n serially connected magnetic tunnel junctions in the storage unit has a plurality of different resistance value states. In this way, a plurality of data write states may be indicated. Therefore, storage and reading in the plurality of data states can be implemented. In the conventional technologies, one storage unit can store only one bit for indicating two states. In comparison, in this way, an area and power consumption of the memory can be reduced when write flexibility is ensured.

On this basis, an embodiment of this application further provides an electronic device. The electronic device includes a circuit board and a memory connected to the circuit board. The memory may be any memory provided above. The circuit board may be a printed circuit board (printed circuit board, PCB). Certainly, the circuit board may be alternatively a flexible printed circuit board (FPC) or the like. This embodiment does not limit the circuit board. Optionally, the electronic device is different types of user equipment or terminal devices such as a computer, a mobile phone, a tablet computer, a wearable device, and an in-vehicle device. The electronic device may be alternatively a network device such as a base station. Optionally, the electronic device further includes a package substrate. The package substrate is fastened to the printed circuit board PCB by using a solder ball. The memory is fastened to the package substrate by using a solder ball. It should be noted that for related description of the memory in the electronic device, reference may be made to the description of the memory in the foregoing embodiment. Details are not described herein again in this embodiment of this application.

According to another aspect of this application, a non-transitory computer readable storage medium used with a computer is further provided. The computer has software for creating an integrated circuit. The computer readable storage medium stores one or more computer readable data structures. The one or more computer readable data structures have photomask data for manufacturing the memory provided in any one of the foregoing diagrams.

In conclusion, the foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A memory, comprising a plurality of storage units distributed in an array, wherein
the storage unit comprises an orbit torque providing line, a first magnetic tunnel junction MTJ, and a second magnetic tunnel junction MTJ;
a free layer of the first MTJ is connected to the orbit torque providing line, and a free layer of the second MTJ is connected to the orbit torque providing line; and
the orbit torque providing line is further connected to a first bit line, a second bit line, and a third bit line, connection ends of the first bit line and the second bit line on the orbit torque providing line are respectively located on two sides of the first MTJ and the second MTJ, and a connection end of the third bit line on the orbit torque providing line is located between the first MTJ and the second MTJ.

2. The memory according to claim 1, wherein a first electrode is disposed on a reference layer of the first MTJ, a second electrode is disposed on a reference layer of the second MTJ, the second electrode is configured to receive a read voltage, and the first electrode is configured to output a read current.

3. The memory according to claim 2, wherein the second electrode and the first electrode are connected to a current detection circuit, the detection circuit is configured to: input the read voltage to the second electrode, and detect the read current of the first electrode, and a total resistance value that is of the first MTJ and the second MTJ and that corresponds to the read current indicates data stored in the storage unit.

4. The memory according to any one of claims 1 to 3, wherein in a write state, signals provided by the first bit line, the second bit line, and the third bit line are used to change a resistance value of the first MTJ and/or the second MTJ; and in a read state, the total resistance value that is of the first MTJ and the second MTJ and that is read from the reference layer of the first MTJ and the reference layer of the second MTJ is used to indicate the data stored in the storage unit.

5. The memory according to any one of claims 1 to 4, wherein the first MTJ and the second MTJ have the same size or different sizes.

6. The memory according to any one of claims 1 to 4, wherein if the first MTJ and the second MTJ have the same size, when the free layer and the reference layer of the first MTJ are in a parallel state and the free layer and the reference layer of the second MTJ are in the parallel state, the resistance value of the first MTJ is the same as the resistance value of the second MTJ, or when the free layer and the reference layer of the first MTJ are in an anti-parallel state and the free layer and the reference layer of the second MTJ are in the anti-parallel state, the resistance value of the first MTJ is the same as the resistance value of the second MTJ; or
if the first MTJ and the second MTJ have different sizes, when the free layer and the reference layer of the first MTJ are in a parallel state and the free layer and the reference layer of the second MTJ are in the parallel state, the resistance value of the first MTJ is different from the resistance value of the second MTJ, or when the free layer and the reference layer of the first MTJ are in an anti-parallel state and the free layer and the reference layer of the second MTJ are in the anti-parallel state, the resistance value of the first MTJ is different from the resistance value of the second MTJ.

7. The memory according to any one of claims 1 to 6, wherein the reference layer of the first MTJ is connected to a source line, and the reference layer of the second MTJ is connected to a read word line by using a gating switch; and
after the read word line gates the gating switch, the total resistance value of the first MTJ and the second MTJ is read from the source line and the read word line.

8. The memory according to any one of claims 1 to 7, wherein the orbit torque providing line is connected to a first bit line by using a first switch, and a control end of the first switch is connected to a write word line;
the orbit torque providing line is connected to a second bit line by using a second switch, and a control end of the second switch is connected to the write word line; and
in a write state, the write word line controls the first switch and the second switch to be on.

9. A memory, comprising storage units distributed in an array, wherein the storage unit comprises n serially connected tunnel junctions, n is an integer greater than or equal to 2, a first end of an i^{th} tunnel junction is connected to an i^{th} bit line, and a second end of the i^{th} tunnel junction is connected to an (i+1)^{th} bit line.

10. The memory according to claim 9, wherein a first end of a first tunnel junction is connected to a current detection circuit by using a first bit line, a second end of the i^{th} tunnel junction is connected to the current detection circuit by using the (i+1)^{th} bit line, the current detection circuit is configured to: input a read voltage on the first bit line, and detect a read current on the (i+1)^{th} bit line, and a total resistance value that is of the n serially connected tunnel junctions and that corresponds to the read current indicates data stored in the storage unit.

11. The memory according to claim 9 or 10, wherein in a write state, a signal provided by the bit line is used to change resistance of the tunnel junction; and in a read state, the total resistance value that is of the n serially connected tunnel junctions and that is read from the first bit line and the (n+1)^{th} bit line is used to indicate the data stored in the storage unit.

12. The memory according to any one of claims 9 to 11, wherein the tunnel junction comprises an MTJ or a ferroelectric tunnel junction FTJ.

13. The memory according to any one of claims 9 to 11, wherein the tunnel junctions have the same size or different sizes.

14. The memory according to claim 12, wherein the MTJ comprises a reference layer, a tunneling layer, and a free layer, and when magnetization directions of the reference layer and the free layer are the same, the MTJ is a first resistor; or when magnetization directions of the reference layer and the free layer are different, the MTJ is a second resistor.

15. The memory according to claim 12, wherein the FTJ comprises a first electrode, a ferroelectric layer, and a second electrode, and when the ferroelectric layer is in a first polarization direction, the FTJ is a first resistor; or when the ferroelectric layer is in a second polarization direction, the FTJ is a second resistor.

16. The memory according to any one of claims 9 to 15, wherein the first end of the first tunnel junction is connected to the first bit line by using a first switch, and a second end of an n^{th} tunnel junction is connected to an (n+1)^{th} bit line by using a second switch; and a control end of the first switch and a control end of the second switch are connected to a word line; and
in the write state or the read state, the word line controls the first switch and the second switch to be on.

17. An electronic device, comprising a circuit board and a memory connected to the circuit board, wherein the memory is the memory according to any one of claims 1 to 16.
